# EUROPEAN PATENT APPLICATION

(11) **EP 4 604 170 A1**
(43) Date of publication of application: **20.08.2025**
(21) Application number: 24181594.3
(22) Date of filing: 12.06.2024
(51) Int. Cl.: H01L 21/18, H01L 21/268, H01L 21/02, H01L 21/78

(54) **PROCESS OF FORMING A THIN SEMICONDUCTOR LAYER BONDED TO A PROCESSING SUBSTRATE**

(30) Priority: 13.02.2024 US 202418439823
(71) Applicant: Semiconductor Components Industries, LLC, Scottsdale, AZ 85250 (US)
(72) Inventor: KOCIAN, Karel, 74258 Pribor (CZ); POSTULKA, Dusan, 70030 Ostrava (CZ); JARINA, Juraj, 01501 Rajec (SK)
(74) Representative: Manitz Finsterwald Patent- und Rechtsanwaltspartnerschaft mbB

(57) **Abstract**

In an aspect, a process can include bonding a carrier substrate to a first major surface of a donor substrate; generating a laser damage zone within the donor substrate; bonding a processing substrate to a second major surface of the donor substrate, wherein the second major surface is opposite the first major surface; and separating (1) the processing substrate and a device portion of the donor substrate and (2) the carrier substrate and a remaining portion of the donor substrate from each other. In another aspect, an electronic device can include a device portion of a SiC substrate, wherein the device portion includes at least part of an electronic circuit element. A processing substrate can be bonded the device portion, wherein the processing substrate can withstand processing conditions when fabricating the electronic device.

## Description

### FIELD OF THE DISCLOSURE

The present disclosure relates to processes and electronic devices, and more particularly, to processes of forming a thin semiconductor layer bonded to a processing substrate and electronic devices including the thin semiconductor layer.

### RELATED ART

Electronic devices can be fabricated using semiconductor materials. Some semiconductor materials can be relatively expensive, or shortages of any particular semiconductor material can be problematic for producing electronic devices in a time frame that meets customer expectations. Techniques exist for producing relatively thin layers of a semiconductor material from a relatively thick substrate of the semiconductor material. The relatively thin layers can be difficult to process using typical fabrication processes. A need exists for a robust processing for producing relatively thin layers of the semiconductor material, wherein the relatively thin layers can withstand a semiconductor fabrication process.

### BRIEF DESCRIPTION OF THE DRAWINGS

Implementations are illustrated by way of example and are not limited in the accompanying figures.
FIG. 1 includes a process flow for producing a relatively thin layer of a semiconductor material and fabricating a finished electronic device from the relatively thin layer.
FIG. 2 includes an illustration of a cross-sectional view of a carrier substrate and a donor substrate before bonding.
FIG. 3 includes an illustration of a cross-sectional view of the carrier substrate and the donor substrate after bonding.
FIG. 4 includes an illustration of a cross-sectional view of the carrier substrate and the donor substrate during generating laser damage within the donor substrate.
FIG. 5 includes an illustration of a top view of the donor substrate showing a relationship between a laser direction and a cleavage plane.
FIG. 6 includes an illustration of a top view of the donor substrate showing a relationship between a laser direction and a plurality of cleavage planes.
FIG. 7 includes an illustration of a cross-sectional view of a processing substrate and a carrier-donor workpiece before bonding.
FIG. 8 includes an illustration of a cross-sectional view of a processing substrate and a carrier-donor workpiece after bonding.
FIG. 9 includes an illustration of a cross-sectional view of a workpiece including a processing substrate and a device portion of the donor substrate and another workpiece including a carrier substrate and a remaining portion of the donor substrate after separating the workpieces.
FIG. 10 includes an illustration of a cross-sectional view of the workpiece including the processing substrate and device portion of the donor substrate after polishing the device portion.
FIG. 11 includes an illustration of a cross-sectional view of a portion of the workpiece of FIG. 10 after forming a vertical transistor.
FIG. 12 includes an illustration of a cross-sectional view of a portion of the workpiece of FIG. 10 after forming a transistor and a resistor.
FIG. 13 includes an illustration of a cross-sectional view of a portion of the workpiece including a terminal wire bonded to a lead.
FIG. 14 includes an illustration of a cross-sectional view of a portion of the workpiece including a terminal and a conductive bump contacting the terminal.

Skilled artisans appreciate that elements in the figures are illustrated for simplicity and clarity and have not necessarily been drawn to scale. For example, the dimensions of some of the elements in the figures may be exaggerated relative to other elements to help to improve understanding of implementations of the inventive concepts.

### DETAILED DESCRIPTION

The following description in combination with the figures is provided to assist in understanding the teachings disclosed herein. The following description will focus on specific implementations and implementations of the teachings. This focus is provided to assist in describing the teachings and should not be interpreted as a limitation on the scope or applicability of the teachings. However, other implementations can be used based on the teachings as disclosed in this application.

As used in this specification, length and width are measured in directions along or parallel to a major surface of a substrate or a semiconductor layer. Depth, height, and thickness are measured in directions perpendicular to the major surface of the substrate or the semiconductor layer.

The term "electrically coupled" is intended to mean a connection, linking, or association of two or more electronic components, circuits, systems, or any combination of: (1) at least one electronic component, (2) at least one circuit, or (3) at least one system in such a way that a signal (e.g., current, voltage, or optical signal) may be partly or completely transferred from one to another. A subset of "electrically coupled" can include an electrical connection between two electronic components. In a circuit diagram, a node corresponds to an electrical connection between the electronic components. Thus, an electrical connection is a specific type of electrical coupling; however, not all electrical couplings are electrical connections. Other types of electrical coupling include capacitive coupling, resistive coupling, and inductive coupling.

The terms "horizontal," "lateral," and their variants are in directions along or parallel to a major surface of a substrate or semiconductor layer, and the terms "vertical," "height," "depth," and their variants are in directions perpendicular to a major surface of the substrate or the semiconductor layer. Two objects that are laterally offset can be at the same or different elevations.

The terms "overlap," "underlap," and their variants refer to at least portions of regions or other features that lie along a vertical line that is perpendicular to a plane defined by a major surface. Components or features that overlap or underlap each other may or may not be in physical contact with each other.

The term "semiconductor composition" is intended to refer to a material of a substrate, layer, or region that provides the semiconductor characteristics to such substrate, layer, or region. The material may or may not include dopants. For example, an n-type doped Si layer and a p-type doped Si layer have the same semiconductor composition, namely Si. However, an n-type doped Si layer and an n-type doped GaN layer have different semiconductor compositions, as Si and GaN provide the semiconductor characteristics and are different from each other.

Unless explicated stated to the contrary, a border between a relatively heavier doped region or layer and an immediately adjacent and relatively lighter doped region or layer of the same conductivity type is where the dopant concentration between the regions or layers is 1.1 times higher than a peak dopant concentration of the relatively lower doped region or layer.

The terms "on," "overlying," and "over" may be used to indicate that two or more elements are in direct physical contact with each other. However, "over" may also mean that two or more elements are not in direct contact with each other. For example, "over" may mean that one element is above another element, but the elements do not contact each other and may have another element or elements between the two elements.

The terms "comprises," "comprising," "includes," "including," "has," "having" or any other variation thereof, are intended to cover a non-exclusive inclusion. For example, a method, article, or apparatus that comprises a list of features is not necessarily limited only to those features but may include other features not expressly listed or inherent to such method, article, or apparatus. Further, unless expressly stated to the contrary, "or" refers to an inclusive-or and not to an exclusive-or. For example, a condition A or B is satisfied by any one of the following: A is true (or present) and B is false (or not present), A is false (or not present) and B is true (or present), and both A and B are true (or present).

Also, the use of "a" or "an" is employed to describe elements, components and other features described herein. This is done merely for convenience and to give a general sense of the scope of the inventive concepts. This description should be read to include one, at least one, or the singular as also including the plural, or vice versa, unless it is clear that it is meant otherwise. For example, when a single item is described herein, more than one item may be used in place of a single item. Similarly, where more than one item is described herein, a single item may be substituted for that more than one item.

The use of the word "about," "approximately," or "substantially" is intended to mean that a value of a parameter is close to a stated value or position. However, minor differences may prevent the values or positions from being exactly as stated. Thus, differences of up to ten percent (10%) (and up to twenty percent (20%) for semiconductor doping concentrations) for the value are reasonable differences from the ideal goal of exactly as described.

Unless otherwise defined, all technical and scientific terms used herein have the same meaning as commonly understood by one of ordinary skill in the art to which these inventive concepts belongs. The materials, methods, and examples are illustrative only and not intended to be limiting. To the extent not described herein, many details regarding specific materials and processing acts are conventional and may be found in textbooks and other sources within the semiconductor and electronic arts.

A laser damage zone can be generated within a donor substrate. A device portion of the donor substrate can be along one side of the laser damage zone, and a remaining portion of the donor substrate can be along an opposite side of the laser damage zone. The donor substate can be bonded to a carrier substrate and a processing substrate when the donor substrate is separated along the laser damage zone. An electronic device can be fabricated using the device portion of the donor substrate, where the fabrication is performed while the processing substrate is bonded to the device portion. The device portion can have a thickness thicker than a semiconductor layer formed using a H⁺ implant technique and thinner than a standalone slice (without a processing or other supporting substrate). Another device portion may be produced from the remaining portion of the donor substrate. The process is well suited for semiconductor materials that are substantially more expensive than monocrystalline Si or where growing an epitaxial layer is difficult. The process works well for donor substrates that have a SiC semiconductor composition.

In an aspect, a process can include bonding a carrier substrate to a first major surface of a donor substrate; generating a laser damage zone within the donor substrate; bonding a processing substrate to a second major surface of the donor substrate, wherein the second major surface is opposite the first major surface; and separating (1) the processing substrate and a device portion of the donor substrate and (2) the carrier substrate and a remaining portion of the donor substrate from each other.

In another aspect, a process can include bonding a carrier substrate to a donor substrate; generating a laser damage zone within the donor substrate; bonding a processing substrate to the donor substrate; separating (1) the processing substrate and a device portion of the donor substrate and (2) the carrier substrate and a remaining portion of the donor substrate from each other; doping a part of the device portion with a dopant; and activating the dopant to form a doped region from the part of the device portion, wherein activating is performed at a temperature of at least 1500 °C.

In a further aspect, an electronic device can include a device portion of a SiC substrate, wherein the device portion has a first major surface and a second major surface opposite the first major surface, and the device portion includes at least part of an electronic circuit element and a terminal electrically coupled to the electronic circuit element, wherein the terminal is along or over the first major surface of the device portion. The electronic device can further include a processing substrate bonded to the second major surface of the device portion, wherein the processing substrate has a thickness no greater than 250 microns and has a melting point greater than 1500 °C.

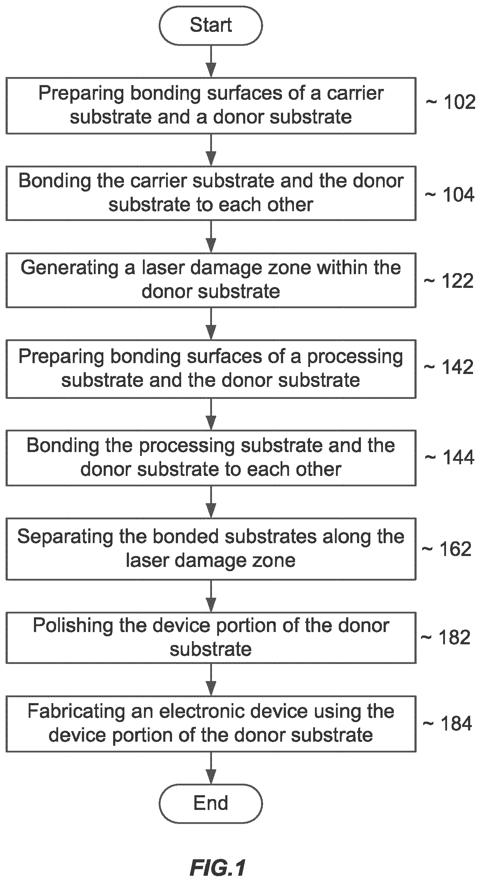

FIG. 1 includes a process flow for fabricating an electronic device using a relatively thin layer of a semiconductor material obtained from a donor substrate. The donor substrate is the source of the relatively thin layer of the semiconductor material. The semiconductor material can have a semiconductor composition and be monocrystalline. An example of the semiconductor composition can be SiC, a III-V semiconductor (for example, GaAs, GaN, or the like), or a II-VI semiconductor. SiC can be difficult to grow, and a relatively high temperature (for example, 1500 °C to 1800 °C) may be used to activate one or more dopants implanted into SiC. While much of the description addresses particular issues with SiC, the concepts described herein can be extended to other semiconductor compositions.

The process described below uses a carrier substrate and a processing substrate. Materials for the processing substrate and, possibly, the carrier substrate may depend on the semiconductor composition of the donor substrate, the bonding and separation operations, and electronic device fabrication. During at least part of the electronic device fabrication, the processing substrate is processed with the thin layer of semiconductor material from the donor substrate. In an implementation, the donor substrate has a semiconductor composition that is monocrystalline SiC that can be a 3C, a 4H, or a 6H polytype.

The thin layer of the semiconductor material and the processing substrate can be exposed to temperatures ranging from room temperature (for example, 20 °C to 25 °C) to the highest temperature to which the thin layer of the semiconductor material and the processing substrate will be exposed. For SiC, dopants can be activated at a temperature in a range from 1500 °C to 1800 °C. Further, epitaxially growing SiC can be performed at a temperature within the same range. Thus, the processing substrate will be exposed to the heat used to activate dopant(s) implanted into a thin layer of the semiconductor material and, if a SiC epitaxial layer is grown, heat during the epitaxial growth.

If the difference between the coefficient of thermal expansions (CTEs) for the thin layer of semiconductor material and the processing substrate is too great, the thin layer of semiconductor material may become damaged when the thin layer of semiconductor material and the processing substrate are cycled between room temperature and the highest temperature during the fabrication process. Due to the large range of temperatures, a higher CTE for the thin layer of the semiconductor material or the processing substrate is at most 2 times the lower CTE for the other of the thin layer of the semiconductor material or the processing substrate.

When the thin layer of semiconductor material and the processing substrate have the same semiconductor composition, the higher CTE is the same as the lower CTE. When the donor substrate (a source of the thin layer of semiconductor material) has a SiC semiconductor composition and the processing substrate is Si₃N₄, the higher CTE is approximately 1.5 times the lower CTE. The melting point of Si₃N₄ is approximately 1900 °C. Thus, processing substrate can include SiC or Si₃N₄ when the donor substrate is doped or undoped monocrystalline SiC. In a particular implementation, the processing substrate can include monocrystalline SiC that meets all of the specifications for use in fabricating electronic devices, polycrystalline SiC, or a monocrystalline SiC ingot where the ingot does not meet all of the specifications for use in fabricating electronic devices ("off-spec SiC").

The processing substrate does not need to be SiC or Si₃N₄ for all implementation. For example, the donor substrate can be doped or undoped monocrystalline GaN, doped or undoped monocrystalline GaAs, or the like. In addition to SiC and Si₃N₄, another material that may be used for the processing substrate can include sapphire, spinel, boron carbide, a refractory metal, a refractory metal nitride, or a refractory metal oxide, so long as SiC, Si₃N₄, sapphire, spinel, boron carbide, the refractory metal, the refractory metal nitride, or the refractory metal oxide has a melting point that is higher than the highest temperature to which it will be exposed and has a CTE sufficiently close to the CTE of the material within the donor substrate.

The material for the carrier substrate has more latitude as compared to the processing substrate. The carrier substrate will not be processed during electronic device fabrication, and thus, will not be exposed to the relatively higher temperatures to which the processing substrate will. In addition to the previously described materials, many other materials may be used. An exemplary material can include Si (monocrystalline or polycrystalline) or a SiO₂-based material, such as quartz, fused silica, glass, or the like.

The process can include preparing bonding surfaces of a carrier substrate and a donor substrate at block 102 in FIG. 1. Before bonding, each of the substrates can have a surface that has a root mean square surface roughness, R_{RMS}, of at most 0.5 nm, nanotopography of at most 5 nm, a local flatness at most 0.5 microns, and substrate warpage of at most 300 microns for a 150 mm or a 200 mm diameter substrate. The limit for substrate warpage may depend in part on the material composition of the substrate, the size of the substrate (width or diameter if generally circular), or both. Grinding, lapping, polishing, or a combination thereof of the bonding surface may be performed to meet the previously discussed criteria. If any one or all of the criteria cannot be met, a different substrate may be substituted.

The donor substrate 220 includes a major surface 222 and a major surface 224 opposite the major surface 222. For the donor substrate 220, the major surfaces 222 and 224 can be ground, lapped, polished, or a combination thereof may be performed at this time. If the ground, lapping, polishing, or a combination thereof of the major surface 222 is performed after generating a laser damage zone and before a subsequent bonding operation, the donor substrate 220 may be separated along the laser damage zone. Skilled artisans can perform a test using another donor substrate of the substantially the same composition and average depth of the laser damage zone to ensure the donor substrate can withstand grinding, lapping, polishing, or a combination thereof after forming the laser damage zone.

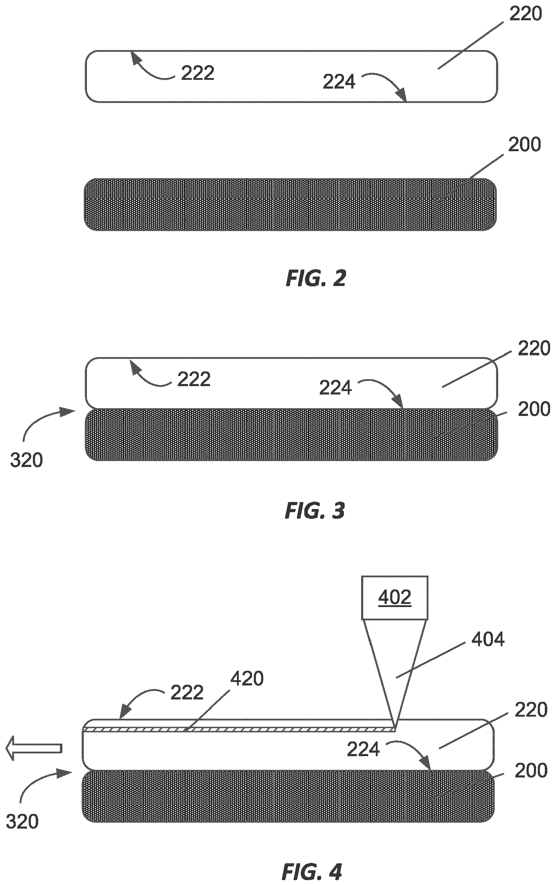

After any or all of the criteria are met, the bonding surfaces of the substrates can be cleaned. In a particular example, an RCA clean can be performed. If a SiO₂-based substrate is used, the oxide removal portion of the RCA clean can be omitted. Another cleaning process may be used to clean the bonding surfaces of the substrates. FIG. 2 includes an illustration of a carrier substrate 200 and a donor substrate 220 after the bonding surfaces have been prepared.

The process can include bonding the carrier substrate and the donor substrate to each other at block 104 in FIG. 1. The substrate bonding can be performed in a wafer-to-wafer bonding system available from EV Group Europe & Asia/Pacific GmbH of St. Florian am Inn, Austria. The bonding can be performed at a temperature in a range from room temperature to 600 °C, at a downforce pressure in a range from 0.03 kPa to 350 kPa, and at an ambient pressure that is less than atmospheric pressure. In a particular implementation, the bonding can be performed at room temperature, at a downforce pressure in a range from 30 kPa to 350 kPa, and at an ambient pressure in a range from 1×10⁻⁹ mbar to 10 mbar. The major surface 224 is bonded to the upper surface of the carrier substrate 200 along an interface 320 in FIG. 3.

The process can further include generating a laser damage zone within the donor substrate at block 122 of FIG. 1. FIG. 4 includes a cross-sectional view as a laser 402 is generating a laser damage zone 420 within the donor substrate 220. The laser energy 404 can be focused at a desired depth within the donor substrate 220. In an implementation, the laser energy may be in the red light, near infrared (IR), or both radiation spectrums. In the same or different implementation, a yttrium-aluminum-garnet (YAG) laser or a sapphire laser may be used. The YAG laser can be doped with Nd (peak emission at 1064 nm), Yb (peak emission at 1030 nm), or Cr (emission in a range from 1350 nm to 1550 nm). The sapphire laser can be doped with Ti and have a peak radiation emission in a range from 620 nm to 1100 nm. If needed or desired, a frequency doubler, tripler, or quadrupler can be used. For example, for a Nd:YAG laser, the emission frequency can be doubled to achieve radiation at 532 nm, tripled to achieve radiation at 355 nm, and quadrupled to achieve radiation at 266 nm. Skilled artisans can select a material for the laser and whether or not a frequency multiplier should be used in generating the laser damage zone 420.

The laser 402, the bonded workpiece that includes the donor substrate 220 and the carrier substrate 200, or both the laser 402 and the bonded workpiece can be moved during the laser damage generation operation. The motion is illustrated by the arrow in FIG. 4. Within the laser damage zone 420, energy from the laser causes damage to the crystal of the donor substrate 220.

The donor substrate 220 may have one or more sets of cleavage planes that intersect the major surface 222 of the donor substrate 220, where each set of cleavage planes has a corresponding crystal direction. Referring to FIG. 4, damage from laser 402 should not significantly propagate in a vertical direction, as such a crack may extend through a significant part or all of the thickness of the donor substrate 220 that lies above, below, or above and below the laser damage zone 420. To reduce the risk of a vertical crack forming, the laser or the workpiece can be moved so that movement is in a direction that is not along a crystal direction corresponding to a set of cleavage planes.

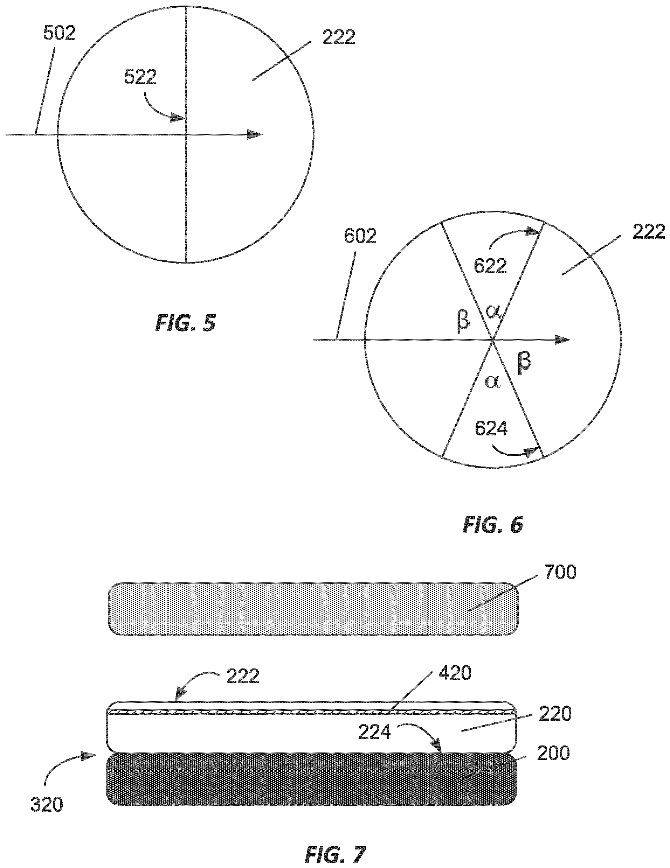

FIG. 5 includes a top view of the donor substrate 220 and a crystal direction 522 that corresponds to a set of cleavage planes that the intersect the major surface 222 of the donor substrate 220. The relative motion of the laser 402 and the donor substrate 220 is illustrated with the arrow 502 and is referred to as the laser direction. Before generating the laser damage zone 420, the workpiece with the donor substrate 220 can be rotated so that the laser direction 502 is perpendicular to the crystal direction 522. Due to manufacturing tolerances, the laser 402 can traverse in the laser direction 502 that is within 5% of being perpendicular to the crystal direction 522. The laser 402 traverses many times along lines that are spaced apart from one another, where the lines are within 5% of being perpendicular to the crystal direction 522.

FIG. 5 includes a donor substrate 220 with a single set of cleavage planes that intersect the major surface 222 of the donor substrate 220 and are parallel to each other. In another implementation, the donor substrate 220 may have a plurality of sets of cleavage planes. FIG. 6 includes a top view of the donor substrate 220 and crystal directions 622 and 624. The crystal direction 622 can correspond to set of cleavage planes that the intersect the major surface 222 of the donor substrate 220, and the crystal direction 624 can correspond to another set of cleavage planes that the intersect the major surface 222 of the donor substrate 220.

Two angles, an acute α and an obtuse angle β, are formed by the intersection of the crystal directions 622 and 624 at the major surface 222. The relative motion of the laser 402 with respect to the donor substrate 220 is illustrated with the arrow 602 and is referred to as the laser direction. To reduce the likelihood of a crack propagating in a vertical direction during generation of the laser damage zone 420, the workpiece with the donor substrate 220 can be rotated so that the laser direction 602 bisects the obtuse angle β. Due to manufacturing tolerances, the laser 402 can traverse in the laser direction 602 that is within 5% of the bisected angle. The laser 402 traverses many times along lines that are spaced apart from one another, where the lines are within 5% of bisecting the obtuse angle β.

In another implementation, the workpiece with the donor substrate 220 can be rotated so that the laser direction 602 bisects the acute angle α. Due to manufacturing tolerances, the laser 402 can traverse in the laser direction 602 that is within 5% of the bisected angle. The laser 402 traverses many times along lines that are spaced apart from one another, where the lines are within 5% of bisecting the acute angle α. The bisected angle based on the obtuse angle β will be closer to being perpendicular to the two sets of cleavage planes. The bisected angle based on the acute angle α provides an alternative if bisecting the obtuse angle β is not used.

The average depth of the laser damage zone 420 can be selected based on the thickness of a device portion of the donor substrate 220 in a finished electronic device. The thickness of the device portion of the donor substrate 220 can be in a range from 11 microns to 150 microns. In an implementation, the thickness of the device portion of the donor substrate 220 can be in a range from 11 microns to 95 microns. The latter range may be useful when the device portion can include a drift region of a power transistor, where, when the power transistor is off the voltage difference between current-carrying electrodes or regions (drain-to-source voltage or collector-to-emitter voltage) is at least 200 V.

A subsequent separation operation is performed, and some of the laser damage from the laser damage zone 420 will be present in a device portion and a remaining portion of the donor substrate 220 after separation. The laser damage along the device and remaining portions of the donor substrate 220 may be removed before they are further processed. Thus, the average depth of the laser damage zone 420 from the major surface 222 is more than the thickness of the device portion of the donor substrate 220 within a finished electronic device. The power of the laser can be adjusted to achieve average depth of the laser damage zone 420.

The laser 402 can traverse the workpiece many times in generating the laser damage zone 420. Each of the passes can be spaced apart from its nearest adjacent pass or pair of nearest adjacent passes by a distance in a range from 20 microns to 500 microns. More closely-spaced passes can make a subsequent separation easier; however, more passes can increase the time spent generating the laser damage zone 420. Skilled artisans can determine the spacing of the passes to achieve a desired balance of ease of separation versus the processing time to generate the laser damage 420.

The process can include preparing bonding surfaces of a processing substrate and the donor substrate at block 142 in FIG. 1. Referring to FIG. 7, the major surface 222 of the donor substrate 220 will be bonded to the bottom surface of the processing substrate 700. The preparation of the bottom surface of the processing substrate 700 can be substantially the same as the upper surface of the carrier substrate 200 before the donor substrate 220 and the upper surface of the carrier substrate 200 were bonded. The major surface 222 may have the surface properties as previously described with respect to block 102 of FIG. 1. Thus, the workpiece that includes the carrier substrate 200 and the donor substrate 220 may only need to have the major surface 222 cleaned and not ground, lapped, or polished.

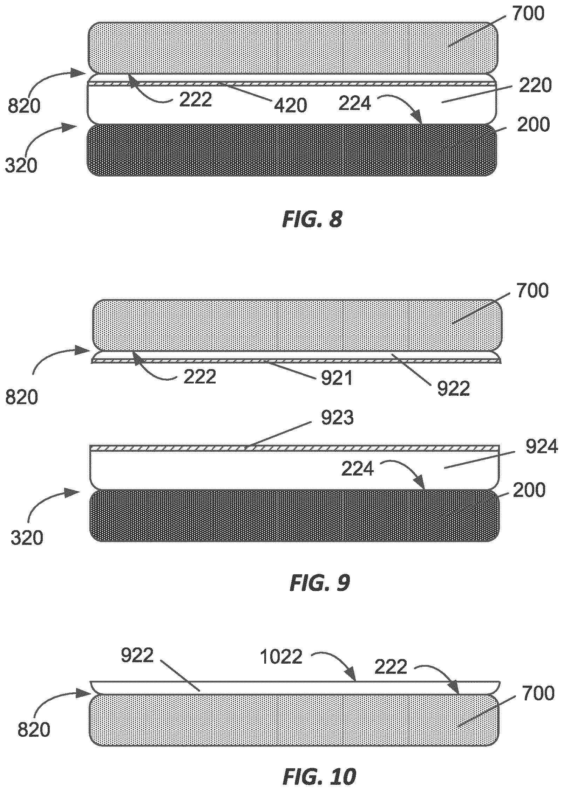

The process can include bonding the processing substrate and the donor substrate to each other at block 144 in FIG. 1. The substrate bonding can be performed in a wafer-to-wafer bonding system available from EV Group Europe & Asia/Pacific GmbH of St. Florian am Inn, Austria. The bonding can be performed at a temperature in a range from room temperature to 600 °C, at a downforce pressure in a range from 0.03 kPa to 350 kPa, and at an ambient pressure that is less than atmospheric pressure. In a particular implementation, the bonding can be performed at room temperature, at a downforce pressure in a range from 30 kPa to 350 kPa, and at an ambient pressure in a range from 1×10⁻⁹ mbar to 10 mbar. The bonding conditions may or may not be different for different materials. Thus, the bonding conditions when bonding the processing substrate 700 to the donor substrate 220 can be the same or different as compared to when bonding the carrier substrate 200 and the donor substrate 220. The major surface 222 is bonded to the lower surface of the processing substrate 700 along an interface 820 in FIG. 8.

The process can further include separating the bonded substrates along the laser damage zone at block 162 in FIG. 1. Referring to FIGs. 8 and 9, the separation occurs along the laser damage zone 420 to form a workpiece that includes the processing substrate 700, a device portion 922 of the donor substrate 220 and a portion 921 of the laser damage zone 420 and another workpiece that includes the carrier substrate 200, a remaining portion 924 of the donor substrate 220 and a portion 923 of the laser damage zone 420. The separation can be performed using sonic energy, thermal cycling, or mechanical separation. The sonic energy may include placing the workpiece illustrated in FIG. 8 into an ultrasonic bath or a megasonic bath.

Thermal cycling can include taking the workpiece in FIG. 8 from room temperature to an elevated temperature and back to room temperature. In another implementation, thermal cycling can include taking the workpiece in FIG. 8 from room temperature to a low temperature and back to room temperature. The elevated temperature or the low temperature may be affected by the thicknesses, CTEs, or thicknesses and CTEs of the substrates 200, 220, 700; location, thickness, and quality (for example, the spacing between laser passes when generating the laser damage zone 420) of the laser damage zone 420; if used, another material that may or may not be in contact with the processing substrate 700 or the carrier substrate 200; or any combination thereof, when the workpiece is taken to an elevated temperature or a low temperature.

In an implementation, the spacing between laser passes may be relatively small, for example, 10 microns to 20 microns. During the separation operation, the workpiece can be exposed to a temperature that is relatively closer to room temperature (for example, as low as -30 °C for the low temperature or as high as +70 °C for the elevated temperature). In another implementation, the spacing between laser passes may be relatively large, for example, 300 microns to 1000 microns. During the separation operation, the workpiece can be exposed to a temperature that is relatively farther from room temperature (for example, as low as -200 °C or as high as +900 °C).

In the same or different implementation, a material can be in contact with the substrate 200 or 700, where the material and the substrate that is coupled to the material have different CTEs. In a particular implementation, the material can be a polymer that contacts the substrate 200 or 700, and the combination of the substrates 200, 220, and 700 and the material may be placed in contact with liquid N₂ or liquid Ar or exposed to a gas at a temperature below -50 °C (for example, gas vaporized from liquid N₂ or liquid Ar or sublimed from CO₂). In another particular implementation, a metal or metal alloy can be attached to or formed along an exposed major surface of the substrate 200 or 700. The workpiece, including the substrates 200, 220, and 700 and the metal or metal alloy, can be exposed to an ambient at relatively higher temperature as compared to the polymer. For example, the workpiece can be exposed to an ambient at 500 °C. For either or both implementations, the difference in CTEs for the material and the substrate most closely coupled to the material may cause the substrate become slightly concave or convex and allow sufficient force to separate the donor substrate 220 along the laser damage zone 420.

Other techniques using thermal processing may be used. The technique selected should allow the donor substrate 220 to separate along the laser damage zone 420 without significantly adversely affecting the donor substrate 220 at locations spaced apart from the laser damage zone 420. For example, cracks that extend through the thickness of the device portion 922 or the remaining portion 924 may not allow the device portion 922 or the remaining portion 924 to be further processed. Skilled artisans may perform an experiment with a particular technique to determine whether such particular technique can be used without significantly adversely affecting the device portion 922 or the remaining portion 924.

A mechanical force can be used during the separation operation. The force can include pulling the substrates 200 and 700 apart, applying a torque to the substrate 200 or 700 while the other substrate of 200 and 700 is being held in place, applying an angular force to a substrate similar to a peeling action, or insertion of a wedge along the laser damage zone 420. Other mechanical forces may be used if needed or desired. In an implementation, the mechanical force can be used in conjunction with another separation technique (for example, sonic energy or thermal processing) to help urge the separation. In this implementation, the mechanical force, by itself, may be insufficient to perform the separation. If the mechanical force is only used to perform the separation, significant damage to the device portion 922, the remaining portion 924, or both may be more likely to occur.

The process can include polishing the device portion of the donor substrate at block 182 of FIG. 1. The workpiece can include the device portion 922 of the donor substrate and the processing substrate 700. After separation, the portion 921 of the laser damage zone 420 along an exposed surface of the device portion 922 of the donor substrate is removed. The damage can be removed by polishing. If needed or desired, grinding or lapping can be performed before polishing. After polishing, a major surface 1022 of the device portion 922 may have the surface properties as previously described with respect to block 102 of FIG. 1. The processing substrate 700 and the device portion 922 are bonded together when the laser damage is removed and reduces the likelihood of the device portion 922 becoming cracked or fractured as compared to the laser damage being removed from the device portion 922 in the absence of the processing substrate 700.

With respect to the workpiece that includes the remaining portion 924 of the donor substrate and the carrier substrate 200, the process can include polishing the remaining portion 924 of the donor substrate. After separation, the portion 923 of the laser damage zone 420 along an exposed surface of the remaining portion 924 of the donor substrate is removed. The damage can be removed by polishing. If needed or desired, grinding or lapping can be performed before polishing. After polishing, an exposed major surface of the remaining portion 924 may have the surface properties as previously described with respect to block 102 of FIG. 1. The workpiece including the remaining portion 924 and the carrier substrate 200 can be used to generate another device portion from the remaining portion 924 if the remaining portion 924 has a sufficient thickness to produce another device portion. Another processing substrate can have its bonding surface prepared as previously described. The process can continue at block 144, where the other processing substrate is bonded to the remaining portion 924 of the donor substrate. If the remaining portion 924 is too thin, the workpiece can be discarded or the remaining portion 924 can be removed and the carrier substrate 200 can be reused.

Returning to the workpiece including the device portion 922 of the donor substrate and the processing substrate 700, the process can further include fabricating an electronic device using the device portion of the donor substrate at block 184 in FIG. 1. Many different types of electronic devices can be fabricated using the workpiece that includes the device portion 922 of the donor substrate and the processing substrate 700. Some examples below are meant to illustrate and not limit the inventive concepts as defined in the appended claims. Many other electronic devices can be fabricated.

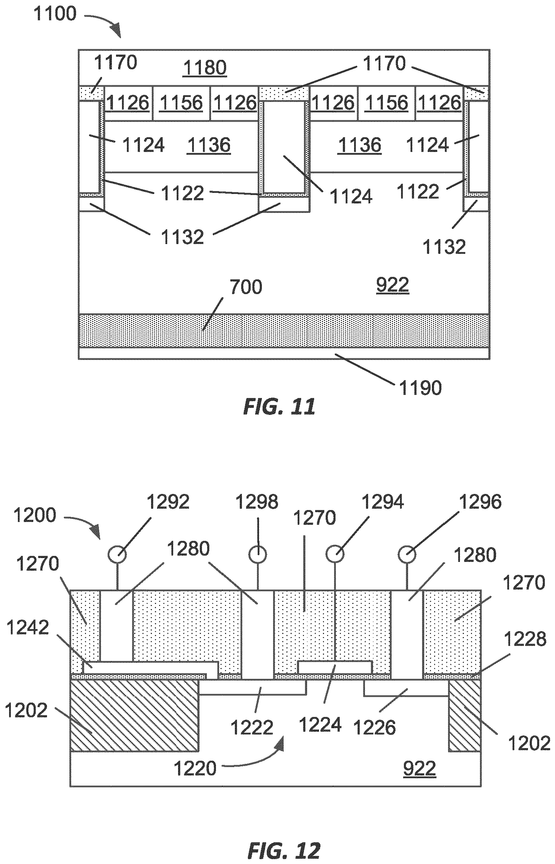

FIG. 11 includes a cross-sectional view of a portion of a workpiece that includes the device portion 922 and the processing substrate 700. The workpiece can be used to fabricate an electronic device that can include a power transistor. Features in FIG. 11 are not drawn to scale so that features of transistor structures of the power transistor can be understood more readily. In FIG. 11, a source electrode 1180 is electrically coupled to source regions 1126 and body contact regions 1156. The source regions 1126 and the body contact regions 1156 are heavily doped to form ohmic contacts with the source electrode 1180. Body regions 1136 are located below the source regions 1126 and the body contact regions 1156 and extend to sidewalls of gate trenches. Portions of the body regions 1136 at the sidewall of the gate trenches include channel regions for the transistor structures. The dopant concentration of the body regions 1136 can be in a range from 1×10¹⁵ atoms/cm³ to 1×10¹⁷ atom/cm³. The dopant concentration can be selected to achieve a desired threshold voltage for the transistor structures. Shield regions 1132 are located along bottoms of the gate trenches and help to reduce the voltage along the bottom of the trenches. The shield regions 1132 can be coupled to the source electrode 1180 at one or more locations not illustrated in FIG. 11. The shield regions 1132 can have a moderate dopant concentration, such as, in a range from 1×10¹⁶ atoms/cm³ to 1×10¹⁸ atom/cm³. If needed or desired, the dopant concentrations for the body regions 1136, the shield regions 1132, or the body regions 1136 and the shield regions 1132 can be outside the ranges described.

The doped regions can be formed from part of the device portion 922 of the donor substrate. The part of the device portion 922 below the body regions 1136 and the shield regions 1132 can be a drift region for the power transistor. The source regions 1126 and the device portion 922 can have the same conductivity type, for example, n-type, and the body contact regions 1156, the body regions 1136, and the shield regions 1132 can have the opposite conductivity type, for example, p-type.

In an implementation, the device portion 922 can have a SiC semiconductor composition. Activating dopants in SiC is performed at a substantially higher temperature as compared to activating dopants in Si. After doping the device portion 922 for the source regions 1126, the body contact regions 1156, the body regions 1136, and the shield regions 1132 and before forming the source electrode 1180, a drain electrode 1190 and features within the gate trenches, the dopants within the workpiece can be activated during an anneal at a temperature in a range of 1500 °C to 1800 °C for a soak time in a range of 10 minutes to 30 minutes. Such a high temperature can limit the materials used for the processing substrate 700. For example, the processing substrate 700 may not include monocrystalline silicon, polycrystalline silicon (polySi), or a SiO₂-based material because such materials may melt or deform during the anneal. In a particular implementation, the processing substrate 700 can include heavily doped polycrystalline SiC (polySiC) or heavily doped off-spec SiC. In this particular implementation, the processing substrate 700 can be part of a drain region for the power transistor.

The workpiece can be patterned to define the gate trenches before or after the anneal to activate the dopants is performed. After the anneal, a gate dielectric layer 1122 and gate electrodes 1124 can be formed within the gate trenches. The gate dielectric layer 1122 can include an oxide, a nitride, an oxynitride, or a combination thereof. The gate electrodes 1124 can include a conductive material, such as heavily doped polySi, W, or the like. The gate electrodes 1124 are recessed within the gate trenches to reduce gate-to-source capacitance. An insulating layer 1170 can be formed over the source regions 1126, the body contact regions 1156, and within remaining portions of the gate trenches. The insulating layer 1170 can include a single film or a plurality of films, wherein the single film or any film of the plurality of films includes an oxide, a nitride, or an oxynitride. The portion of the insulating layer 1170 outside the gate trenches is removed using chemical-mechanical polishing (CMP) or a resist etch back technique.

The source electrode 1180 can be formed by depositing a conductive layer and patterning the conductive layer to form the source electrode 1180. The backside of the workpiece can be ground, lapped, or etched to remove part of the processing substrate 700 to form a remaining portion of the processing substrate 700 as illustrated in FIG. 11. The remaining portion of the processing substrate 700 is illustrated in FIG. 11 and has a thickness in a range from 20 microns to 200 microns. A drain electrode 1190 is attached or formed along the bottom surface of the processing substrate 700. More transistor structures can be formed and are not illustrated, where such more transistor structures are part of the power transistor or a different power transistor. A substantially finished electronic device has been formed.

The workpiece including the transistor structures in FIG. 11 can be singulated into dies, and the dies can be packaged. In an implementation, the packaged dies can be discrete devices.

In another implementation, the power transistor can be a insulated gate bipolar transistor (IGBT). The IGBT can have substantially the same structure as illustrated in FIG. 11; however, the device portion 922 can include a heavily doped region of the same conductivity type as the device portion 922 along the interface with the processing substrate 700, and the processing substrate 700 can be heavily doped and have an opposite conductivity type. For example, the heavily doped region can be n-type, and the processing substrate 700 can be p-type.

In a further implementation, the device portion 922 of the donor substrate can be fabricated to form an integrated circuit. FIG. 12 includes an electronic device 1200 that includes a switching circuit. Although not illustrated, the processing substrate 700 is bonded to the device portion 922 of the donor substrate. The electronic device 1200 includes a V_{DD} terminal 1292 electrically coupled to a resistor 1242, a Vss terminal 1296 electrically coupled to a source region 1226 of a transistor 1220, a gate terminal 1294 electrically coupled to a gate electrode 1224 of the transistor 1220, and an output terminal 1298 electrically coupled to a drain region 1222 of the transistor 1220 and the resistor 1242. Although not illustrated, the device portion 922 can be coupled to the Vss terminal 1296.

In a particular implementation, the switching circuit can be an inverter, where the gate terminal 1294 is an input terminal for the inverter. The transistor 1220 can be an n-channel enhancement-mode insulated gate field-effect transistor, and the resistor 1242 can have a relatively high resistance. When the transistor 1220 is off, the output terminal 1298 can be at substantially V_{DD}. When the transistor 1220 is on, the voltage on the output terminal 1298 is pulled down and becomes substantially Vss. Thus, when the voltage on the gate terminal 1294 is relatively low, the voltage at the output terminal 1298 is relatively high, and when the voltage on the gate terminal 1294 is relatively high, the voltage at the output terminal 1298 is relatively low.

In an implementation, the device portion 922 can have a SiC semiconductor composition. Doped regions can be implanted into the device portion 922 of the donor substrate before forming any of the other features illustrated in FIG. 12. The doped regions can include the drain region 1222 and the source region 1226 and may include optional doped region(s) (not illustrated) between the drain region 1222 and the source region 1226 to adjust the threshold voltage (V_{TH}) of the transistor 1220, formation of lightly-doped drains (LDD) adjacent to the drain region 1222 and the source region 1226, or both the V_{TH} and LDD dopings. The conductivity type of the drain region 1222 and the source region 1226 can be opposite of the conductivity type of the device portion 922. For example, the drain region 1222 and the source region 1226 can be n-type doped, and the device portion 922 can be p-type doped. An anneal can be performed using times and temperatures previously described with respect to the electronic device 1100 in FIG. 11 to activate dopants implanted into the device portion 922.

The device portion 922 can be patterned to define trenches for shallow trench isolation (STI) 1202. Defining the trenches may be performed before or after the anneal to activate the dopants. The material for the STI 1202 can include one or more films of an oxide, a nitride, or an oxynitride. The material can be deposited within the trenches and over the drain region 1222, the source region 1226, and the device portion 922 of the donor substrate. A portion of the material outside of the trenches is removed by CMP or a resist etch back technique to form the STI 1202.

A gate dielectric layer 1228 is formed over the active region of the transistor 1220 and the STI 1202. The gate dielectric layer 1228 can include an oxide, a nitride, or an oxynitride. The gate dielectric layer 1228 is patterned to define an opening where the resistor 1242 will contact the drain region 1222. A polySi layer can be formed over the gate dielectric layer 1228 and within the opening extending through the gate dielectric layer 1228. The polySi layer can be doped or undoped. When the polySi layer is doped, its dopant concentration may correspond to the dopant concentration for the resistor 1242. Alternatively, an undoped polySi layer can be blanket doped (no resist mask over the workpiece during doping) to achieve the dopant concentration for the resistor 1242. A resist mask can be formed over the location where a body of the resistor 1242 is formed, and an exposed portion of the polySi layer corresponds to a location where gate electrode 1224 and terminal connection for the resistor 1242 (corresponding to a location where the conductive via 1280 contacts the resistor 1242) are being formed. The exposed portion of the polySi layer is heavily doped, and the resist mask is removed. The polySi layer can be patterned to form the resistor 1242 and the gate electrode 1224. Many other electronic components can be formed at this time, including other transistors, other resistors, and capacitors.

An interlevel dielectric (ILD) layer 1270 is formed over the workpiece and can include one or more films including an oxide, a nitride, or an oxynitride. The ILD layer 1270 can be planarized using CMP or a resist etch back technique. The ILD layer 1270 can be patterned to define contact openings in which conductive vias 1280 are formed. As illustrated in FIG. 12, contact openings are made to the resistor 1242, the drain region 1222, and the source region 1226. Although not illustrated, a contact opening extends to the gate electrode 1224. Exposed portions of the resistor 1242, the drain region 1222, the gate electrode 1224, and the source region 1226 may or may not be silicided before the remainder of the conductive vias are formed. Further fabrication is performed to form at least one more ILD, at least one interconnect level, and optionally one or more levels of conductive vias. An inductor may or may not be formed. The inductor can be formed from interconnects at different interconnect levels and conductive vias connecting the interconnects at the different levels or may be a planar inductor formed from a conductive layer.

A passivation layer, a polyimide layer, or the like can be formed over the uppermost interconnect level and patterned to expose the terminals (external terminals). The terminals 1292, 1294, 1296, and 1298 may be external terminals or may be internal terminals that connected to other electronic components or other circuits within the electronic device 1200.

The electronic device 1200 can include many other electronic components and circuits and be an integrated circuit. The integrated circuit may be a solid state memory (such as a dynamic random access memory (DRAM), a static random access memory (SRAM), a flash memory, and a magnetoresistive random access memory (MRAM)), a microprocessor, a microcontroller, a graphics processing unit, a digital signal processor, a field programmable gate array (FPGA) or a semiconductor element, a power transistor, a charge coupled-device (CCD), an image sensor, or the like.

An electronic device, such as the electronic device 1100 or 1200, can be ground, lapped, or etched to thin or remove the processing substrate 700. In an implementation, a portion, and not all, of the processing substrate 700 is removed. The remaining portion of the processing substrate 700 may have a thickness in a range from 11 microns to 200 microns. In a particular implementation, the thickness can be in a range of 20 microns to 95 microns, such that the combination of the device portion 922 of the donor substrate 220 and the remaining portion of the processing substrate 700 has a sufficient thickness to withstand forces during singulation and assembly operations and still allow the workpiece to be singulated without complication. The workpiece can be singulated into dies that each include an electronic device,

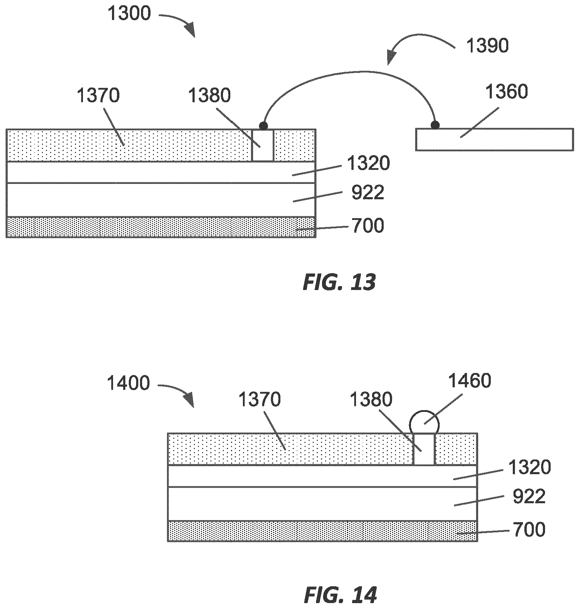

FIG. 13 includes a cross sectional view of an electronic device 1300 and a lead 1360 of a leadframe. The electronic device 1300 includes the remaining portion of the processing substrate 700, the device portion 922 of the donor substrate, an electronic component region 1320 formed at least partly within an upper part of the device portion 922, an ILD layer 1370, and a terminal 1380. The electronic component region 1320 can include a transistor, a resistor, a capacitor, or combination thereof. In practice, the electronic component region 1320 can include thousands of transistor structures and many resistors and capacitors. In practice the combination of the ILD layer 1370 and the terminal 1380 can be a one or more ILD layers and one or more levels of interconnects. Thus, FIG. 13 is a simplified view of an actual electronic device and is used to simplify understanding of post-fabrication operations. A terminal can be exposed along the upper surface of the electronic device and is represented by the terminal 1380. A wire 1390 can be bonded to the terminal 1380 and the lead 1360 to allow a voltage or a signal from outside the die to be received by the terminal 1380 or a voltage or signal from the electronic device 1300 to be transmitted outside the die via the terminal 1380. Other terminals and leads can be wired bonded. The combination of the electronic device 1300 and leads, including the lead 1360, can be encapsulated by a molding compound or may be sealed within a ceramic package.

FIG. 14 includes an electronic device 1400 that is substantially the same as the electronic device 1300 except that a conductive bump 1460 is formed over the terminal 1380. The conductive bump may be reflowed, as illustrated in FIG. 14, or may not be reflowed at this point in the process. The electronic device 1400 can contact or be in close proximity to a printed wiring or circuit board or another die. The other die can be substantially identical to or significantly different from the electronic device 1400. The conductive bumps, including the conductive bump 1460, can be reflowed to electrically couple the electronic device 1400 to such printed wiring or circuit board or other die. The electronic device 1400 may or may not be encapsulated by a molding compound or may be sealed within a ceramic package before or after the electronic device 1400 is electrically coupled to the printed wiring or circuit board or other die.

Many other assembly (post wafer fabrication operations) may be performed instead or in conjunction with the wire bonding or conductive bumps. After reading this specification, skilled artisans can determine a post-fabrication process to meet the needs or desires for a particular application.

Many electrical couplings are described above. Any or all of the electrical couplings can be electrical connections, where an electrical connection is a particular type of an electrical coupling. For example, in FIG. 11, the source electrode 1180 is electrically connected to the source regions 1126 and the body contact regions 1156. The drain electrode 1190 is electrically connected to the processing substrate 700. A gate terminal (not illustrated in FIG. 11) can be electrically connected to the gate electrodes 1124. In FIG. 12, the resistor 1242 has one end electrically connected to the V_{DD} terminal 1292 and another end that is electrically connected to the source region 1226 and the output terminal 1298. For the electronic device 1200, the processing substrate 700 (not illustrated in FIG. 12) can be electrically connected to ground.

A device portion of a donor substrate can have a thickness that is well suited for fabrication of electronic devices. The device portion can be thicker than a slice produced using a H⁺ implant process that, in practice, may be limited to a thickness less than 10 microns. The donor substrate can be bonded to a processing substrate before the device and remaining portions of the donor substate are separated from each other. The processing substrate allows the device portion of the donor substrate to have a thickness that may otherwise be too thin to withstand handling and processing conditions when fabricating electronic components within the device portion in the absence of the processing or another substrate that would provide mechanical support for the device portion. In the absence of the processing substrate, a standalone SiC slice may be 350 microns thick or thicker in order to withstand handling and processing conditions of a fabrication process. The process as described herein can produce more device portions as compared to the standalone SiC slice from a SiC ingot because the thickness of the device portions can be substantially thinner than the standalone SiC slice.

Further, because the donor substrate and the processing substrate are bonded together before the separation operation, a post-separation bonding operation is obviated.

The processing substrate can be selected from a variety of materials, provided the selected material can withstand the highest processing temperature used in the fabrication process and has a CTE that is reasonably close to the CTE of the device portion of the donor substrate.

Many different aspects and implementations are possible. Some of those aspects and implementations are described below. After reading this specification, skilled artisans will appreciate that those aspects and implementations are only illustrative and do not limit the scope of the inventive concepts. Implementations may be in accordance with any one or more of the implementations as listed below.

Implementation 1. A process can include bonding a carrier substrate to a first major surface of a donor substrate; generating a laser damage zone within the donor substrate; bonding a processing substrate to a second major surface of the donor substrate, wherein the second major surface is opposite the first major surface; and separating (1) the processing substrate and a device portion of the donor substrate and (2) the carrier substrate and a remaining portion of the donor substrate from each other.

Implementation 2. The process of Implementation 1 further includes heating the processing substrate and the device portion at a temperature of at least 1500 °C after separating (1) the processing substrate and the device portion of the donor substrate and (2) the carrier substrate and the remaining portion of the donor substrate from each other.

Implementation 3. The process of Implementation 1, wherein after bonding the carrier substrate to the first major surface of the donor substrate, the donor substrate has a set of cleavage planes that intersects the first major surface along a crystal direction, and generating the laser damage zone includes traversing a laser in a laser direction that is within 5% of being perpendicular to the crystal direction.

Implementation 4. The process of Implementation 1, wherein after bonding the carrier substrate to the first major surface of the donor substrate, the donor substrate has a first set of first cleavage planes and a second set of second cleavage planes, wherein the first set of first cleavage planes intersects the first major surface along a first crystal direction, the second set of second cleavage planes intersects the first major surface along a second crystal direction, and the first crystal direction and the second crystal direction intersect along the first major surface of the donor substrate at an angle, and generating the laser damage zone includes traversing a laser in a laser direction that is within 5% of bisecting the angle.

Implementation 5. The process of Implementation 1 further includes polishing the device portion of the donor substrate after separating (1) the processing substrate and the device portion of the donor substrate and (2) the carrier substrate and the remaining portion of the donor substrate from each other.

Implementation 6. The process of Implementation 5, wherein, after polishing the device portion, the device portion has a thickness in a range from 11 microns to 99 microns.

Implementation 7. The process of Implementation 5 further includes forming an electronic circuit element at least partly within the device portion of the donor substrate.

Implementation 8. The process of Implementation 1, wherein separating (1) the processing substrate and the device portion of the donor substrate and (2) the carrier substrate and the remaining portion of the donor substrate from each other includes exposing the carrier substrate, the donor substrate, and the processing substrate to sonic energy.

Implementation 9. The process of Implementation 1, wherein separating the processing substrate and the device portion of the donor substrate and the carrier substrate and the remaining portion of the donor substrate from each other includes heating, cooling, or both heating and cooling the carrier substrate, the donor substrate, and the processing substrate.

Implementation 10. The process of Implementation 1, wherein separating the processing substrate and the device portion of the donor substrate and the carrier substrate and the remaining portion of the donor substrate from each other includes applying a mechanical force to the carrier substrate, the donor substrate, and the processing substrate.

Implementation 11. The process of Implementation 1, wherein the donor substrate includes monocrystalline SiC, and the processing substrate includes SiC or Si₃N₄.

Implementation 12. The process of Implementation 1, wherein the processing substrate includes sapphire, spinel, boron carbide, a refractory metal, a refractory metal nitride, or a refractory metal oxide, wherein sapphire, spinel, boron carbide, the refractory metal, the refractory metal nitride, or the refractory metal oxide has a melting point of at least 1500 °C and has a coefficient of thermal expansion that is within a range from 50% to 150% of a coefficient of thermal expansion of the donor substrate.

Implementation 13. A process can include bonding a carrier substrate to a donor substrate; generating a laser damage zone within the donor substrate; bonding a processing substrate to the donor substrate; separating (1) the processing substrate and a device portion of the donor substrate and (2) the carrier substrate and a remaining portion of the donor substrate from each other; doping a part of the device portion with a dopant; and activating the dopant to form a doped region from the part of the device portion, wherein activating is performed at a temperature of at least 1500 °C.

Implementation 14. The process of Implementation 13 further includes singulating the device portion and the processing substrate after annealing the device portion and the processing substrate to form a plurality of dies.

Implementation 15. The process of Implementation 14 further includes wire bonding a lead of a leadframe and a terminal of a particular die of the plurality of dies to each other; or forming a conductive bump over the terminal of the particular die, such that the conductive bump and terminal are electrically coupled to each other.

Implementation 16. The process of Implementation 14, wherein a particular die of the plurality of dies includes a plurality of transistor structures.

Implementation 17. An electronic device can include a device portion of a SiC substrate and a processing substrate. The device portion can have a first major surface and a second major surface opposite the first major surface, and the device portion can include at least part of an electronic circuit element and a terminal electrically coupled to the electronic circuit element, wherein the terminal is along or over the first major surface of the device portion. The processing substrate can be bonded to the second major surface of the device portion, wherein the processing substrate has a thickness no greater than 250 microns and has a melting point greater than 1500 °C.

Implementation 18. The electronic device of Implementation 17 further includes a conductive bump electrically coupled to the terminal.

Implementation 19. The electronic device of Implementation 17 further includes a lead and a wire bonded to the terminal and the lead.

Implementation 20. The electronic device of Implementation 17, wherein the device portion has a thickness in a range from 11 microns to 150 microns, and the processing substrate has a thickness in a range from 20 microns to 200 microns.

Implementation 21. The electronic device of Implementation 17, wherein the processing substrate has a coefficient of thermal expansion that is within a range from 50% to 150% of a coefficient of thermal expansion of SiC.

Note that not all of the activities described above in the general description or the examples are required, that a portion of a specific activity may not be required, and that one or more further activities may be performed in addition to those described. Still further, the order in which activities are listed is not necessarily the order in which they are performed.

Benefits, other advantages, and solutions to problems have been described above with regard to specific implementations. However, the benefits, advantages, solutions to problems, and any feature(s) that may cause any benefit, advantage, or solution to occur or become more pronounced are not to be construed as a critical, required, or essential feature of any or all the claims.

The specification and illustrations of the implementations described herein are intended to provide a general understanding of the structure of the various implementations. The specification and illustrations are not intended to serve as an exhaustive and comprehensive description of all of the elements and features of apparatus and systems that use the structures or methods described herein. Separate implementations may also be provided in combination in a single implementation, and conversely, various features that are, for brevity, described in the context of a single implementation, may also be provided separately or in any subcombination. Further, reference to values stated in ranges includes each and every value within that range. Many other implementations may be apparent to skilled artisans only after reading this specification. Other implementations may be used and derived from the disclosure, such that a structural substitution, logical substitution, or another change may be made without departing from the scope of the disclosure. Accordingly, the disclosure is to be regarded as illustrative rather than restrictive.

Some of the inventive concepts can include the following items.

Item 1. A process, comprising:
bonding a carrier substrate to a first major surface of a donor substrate;
generating a laser damage zone within the donor substrate;
bonding a processing substrate to a second major surface of the donor substrate, wherein the second major surface is opposite the first major surface; and
separating (1) the processing substrate and a device portion of the donor substrate and (2) the carrier substrate and a remaining portion of the donor substrate from each other.

Item 2. The process of Item 1, further comprising:
heating the processing substrate and the device portion at a temperature of at least 1500 °C after separating (1) the processing substrate and the device portion of the donor substrate and (2) the carrier substrate and the remaining portion of the donor substrate from each other.

Item 3. The process of Item 1 or 2, wherein:
after bonding the carrier substrate to the first major surface of the donor substrate, the donor substrate has a set of cleavage planes that intersects the first major surface along a crystal direction, and
generating the laser damage zone comprises traversing a laser in a laser direction that is within 5% of being perpendicular to the crystal direction.

Item 4. The process of Item 1 or 2, wherein:
after bonding the carrier substrate to the first major surface of the donor substrate, the donor substrate has a first set of first cleavage planes and a second set of second cleavage planes, wherein the first set of first cleavage planes intersects the first major surface along a first crystal direction, the second set of second cleavage planes intersects the first major surface along a second crystal direction, and the first crystal direction and the second crystal direction intersect along the first major surface of the donor substrate at an angle, and
generating the laser damage zone comprises traversing a laser in a laser direction that is within 5% of bisecting the angle.

Item 5. The process of Item 1 or 2, further comprising polishing the device portion of the donor substrate after separating (1) the processing substrate and the device portion of the donor substrate and (2) the carrier substrate and the remaining portion of the donor substrate from each other.

Item 6. The process of Item 5, wherein, after polishing the device portion, the device portion has a thickness in a range from 11 microns to 99 microns.

Item 7. The process of Item 5, further comprising forming an electronic circuit element at least partly within the device portion of the donor substrate.

Item 8. The process of any one of Items 1 to 7, wherein separating (1) the processing substrate and the device portion of the donor substrate and (2) the carrier substrate and the remaining portion of the donor substrate from each other comprises exposing the carrier substrate, the donor substrate, and the processing substrate to sonic energy.

Item 9. The process of one of Items 1 to 7, wherein separating (1) the processing substrate and the device portion of the donor substrate and (2) the carrier substrate and the remaining portion of the donor substrate from each other comprises heating, cooling, or both heating and cooling the carrier substrate, the donor substrate, and the processing substrate.

Item 10. The process of one of Items 1 to 9, wherein separating (1) the processing substrate and the device portion of the donor substrate and (2) the carrier substrate and the remaining portion of the donor substrate from each other comprises applying a mechanical force to the carrier substrate, the donor substrate, and the processing substrate.

Item 11. The process of one of Items 1 to 10, wherein the donor substrate includes monocrystalline SiC, and the processing substrate comprises SiC or Si₃N₄.

Item 12. A process, comprising:
bonding a carrier substrate to a donor substrate;
generating a laser damage zone within the donor substrate;
bonding a processing substrate to the donor substrate;
separating (1) the processing substrate and a device portion of the donor substrate and (2) the carrier substrate and a remaining portion of the donor substrate from each other;
doping a part of the device portion with a dopant; and
activating the dopant to form a doped region from the part of the device portion, wherein activating is performed at a temperature of at least 1500 °C.

Item 13. The process of Item 12, further comprising:
singulating the device portion and the processing substrate after annealing the device portion and the processing substrate to form a plurality of dies.

Item 14. The process of Item 13, further comprising:
wire bonding a lead of a leadframe and a terminal of a particular die of the plurality of dies to each other; or
forming a conductive bump over the terminal of the particular die, such that the conductive bump and terminal are electrically coupled to each other.

Item 15. The process of Item 13, wherein a particular die of the plurality of dies includes a plurality of transistor structures.

## Claims

1. A process, comprising:
bonding a carrier substrate to a first major surface of a donor substrate;
generating a laser damage zone within the donor substrate;
bonding a processing substrate to a second major surface of the donor substrate, wherein the second major surface is opposite the first major surface; and
separating (1) the processing substrate and a device portion of the donor substrate and (2) the carrier substrate and a remaining portion of the donor substrate from each other.

2. The process of claim 1, further comprising:
heating the processing substrate and the device portion at a temperature of at least 1500 °C after separating (1) the processing substrate and the device portion of the donor substrate and (2) the carrier substrate and the remaining portion of the donor substrate from each other.

3. The process of claim 1 or 2, wherein:
after bonding the carrier substrate to the first major surface of the donor substrate, the donor substrate has a set of cleavage planes that intersects the first major surface along a crystal direction, and
generating the laser damage zone comprises traversing a laser in a laser direction that is within 5% of being perpendicular to the crystal direction.

4. The process of claim 1 or 2, wherein:
after bonding the carrier substrate to the first major surface of the donor substrate, the donor substrate has a first set of first cleavage planes and a second set of second cleavage planes, wherein the first set of first cleavage planes intersects the first major surface along a first crystal direction, the second set of second cleavage planes intersects the first major surface along a second crystal direction, and the first crystal direction and the second crystal direction intersect along the first major surface of the donor substrate at an angle, and
generating the laser damage zone comprises traversing a laser in a laser direction that is within 5% of bisecting the angle.

5. The process of claim 1 or 2, further comprising polishing the device portion of the donor substrate after separating (1) the processing substrate and the device portion of the donor substrate and (2) the carrier substrate and the remaining portion of the donor substrate from each other.

6. The process of claim 5, wherein, after polishing the device portion, the device portion has a thickness in a range from 11 microns to 99 microns.

7. The process of claim 5, further comprising forming an electronic circuit element at least partly within the device portion of the donor substrate.

8. The process of any one of claims 1 to 7, wherein separating (1) the processing substrate and the device portion of the donor substrate and (2) the carrier substrate and the remaining portion of the donor substrate from each other comprises exposing the carrier substrate, the donor substrate, and the processing substrate to sonic energy.

9. The process of any one of claims 1 to 7, wherein separating (1) the processing substrate and the device portion of the donor substrate and (2) the carrier substrate and the remaining portion of the donor substrate from each other comprises heating, cooling, or both heating and cooling the carrier substrate, the donor substrate, and the processing substrate.

10. The process of any one of claims 1 to 9, wherein separating (1) the processing substrate and the device portion of the donor substrate and (2) the carrier substrate and the remaining portion of the donor substrate from each other comprises applying a mechanical force to the carrier substrate, the donor substrate, and the processing substrate.

11. The process of any one of claims 1 to 10, wherein the donor substrate includes monocrystalline SiC, and the processing substrate comprises SiC or Si₃N₄.

12. A process, comprising:
bonding a carrier substrate to a donor substrate;
generating a laser damage zone within the donor substrate;
bonding a processing substrate to the donor substrate;
separating (1) the processing substrate and a device portion of the donor substrate and (2) the carrier substrate and a remaining portion of the donor substrate from each other;
doping a part of the device portion with a dopant; and
activating the dopant to form a doped region from the part of the device portion, wherein activating is performed at a temperature of at least 1500 °C.

13. The process of claim 12, further comprising:
singulating the device portion and the processing substrate after annealing the device portion and the processing substrate to form a plurality of dies.

14. The process of claim 13, further comprising:
wire bonding a lead of a leadframe and a terminal of a particular die of the plurality of dies to each other; or
forming a conductive bump over the terminal of the particular die, such that the conductive bump and terminal are electrically coupled to each other.

15. The process of claim 13, wherein a particular die of the plurality of dies includes a plurality of transistor structures.
